# EUROPEAN PATENT APPLICATION

(11) **EP 3 993 568 A1**
(43) Date of publication of application: **04.05.2022**
(21) Application number: 21198579.1
(22) Date of filing: 23.09.2021
(51) Int. Cl.: H05K 1/02

(54) **FERROMAGNETIC MATERIAL TO SHIELD MAGNETIC FIELDS IN SUBSTRATE**

(30) Priority: 03.11.2020 US 202017088135
(71) Applicant: INTEL Corporation, Santa Clara, CA 95054 (US)
(72) Inventor: HEINISUO, Sami, Portland, 97221 (US); GOHLKE, Paul, Beaverton, 97007 (US); MANSUKOSKI, Kari, Hillsboro, 97006 (US)
(74) Representative: Samson & Partner Patentanwälte mbB

(57) **Abstract**

Embodiments of the present disclosure are directed to a substrate with a plurality of layers including a top layer (102a,102b), one or more intermediate layers (106) and a bottom layer (108). Ferromagnetic material (104) applied to a first of the one or more intermediate layers (104) in an area underneath a magnetic source (100) disposed on an outer surface of the top layer (102a,102b), where the ferromagnetic material (104) is to provide a shield for signal routing traces in one or more other intermediate layers (106) or the bottom layer (108) underneath the first intermediate layer (106), from a magnetic field produced by the magnetic source (100). Other embodiments may be described and/or claimed.

## Description

### Technical Field

Embodiments of the present disclosure generally relate to the field of printed circuit boards (PCB), and in particular to shielding areas in lower layers of the PCB from magnetic fields.

### Background

Circuitry routing within PCBs underneath inductors and other electromagnetic interference (EMI) emitting components may have noise induced into signals carried in the circuitry.

### Brief Description of the Drawings

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.
FIG. 1A-1G show side views of various examples of laminating ferrite into a PCB structure to create magnetic shielding for areas in lower layers within the PCB structure, in accordance with various embodiments.
FIG. 2A-2B show top-down views of circuit routing on a PCB in a legacy implementation, in accordance with various embodiments.
FIG. 3 is a process for applying ferromagnetic material to shield magnetic fields in a substrate, in accordance with various embodiments.
FIG. 4 schematically illustrates a computing device 400 in accordance with one embodiment.

### Detailed Description

Embodiments of the present disclosure are directed to an apparatus that includes a substrate with a plurality of layers including a top layer, one or more intermediate layers and a bottom layer, and ferromagnetic material applied to a first of the one or more intermediate layers in an area underneath a magnetic source disposed on an outer surface of the top layer, where the ferromagnetic material is to provide a shield for signal routing traces in one or more other intermediate layers or the bottom layer underneath the first intermediate layer, from a magnetic field produced by the magnetic source.

In embodiments, designing PCB circuit routing under inductors and other EMI emitting components can be challenging due to magnetic fields inducing noise into other signals. In embodiments, by implementing ferromagnetic material, which may also be referred to as embedding ferrite, into layers of a PCB reduces routing constraints otherwise required to avoid magnetic fields that may adversely affect routing. By laminating ferromagnetic material as part of the layers of the PCB structure to act as a magnetic shield, additional space may be freed up on the PCB. In addition, PCB board size may also be decreased. As a result, customer products battery size and capacity may be increased, and overall costs reduced. In embodiments, freeing up PCB space may reduce the PCB outline size and thus increase the battery size within the available chassis space.

In legacy implementations, high-speed signal traces or power supply traces are not routed under power inductors, sometimes all the way through the PCB board stack. This results in wider PCB area requirements for system implementation. In legacy implementations, signal routing is still done under power inductors, but these designs have a risk of noisy, poor performing signals during operation, resulting in unexpected system behavior such as poorly performing buses or unexpected system resets.

In embodiments, ferrite is laminated into the PCB structure to create magnetic shielding so that high current carrying components and traces within the PCB are magnetically shielded from other signals which are typically susceptible to noise. These designs may allow signal traces to be routed directly underneath the power delivery circuitry inductors and under the high current carrying traces and power. In embodiments, a low frequency wireless antenna may be embedded into a PCB by laminating ferrite on a layer of a PCB substrate and thus isolating antenna magnetic field from the other layers of the PCB. Embedding wireless application antenna ferrite into the PCB structure will allow a thinner total PCB assembly stack because the antenna ferrite would not need to reside on top of the PCB, as it does reside in legacy implementations. Other embodiments using this technique include isolating high speed traces from the power supply traces, isolating two or more high speed traces from each other, or isolating two or more power supply traces from each other.

In the following description, various aspects of the illustrative implementations will be described using terms commonly employed by those skilled in the art to convey the substance of their work to others skilled in the art. However, it will be apparent to those skilled in the art that embodiments of the present disclosure may be practiced with only some of the described aspects. For purposes of explanation, specific numbers, materials, and configurations are set forth in order to provide a thorough understanding of the illustrative implementations. It will be apparent to one skilled in the art that embodiments of the present disclosure may be practiced without the specific details. In other instances, well-known features are omitted or simplified in order not to obscure the illustrative implementations.

In the following detailed description, reference is made to the accompanying drawings that form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

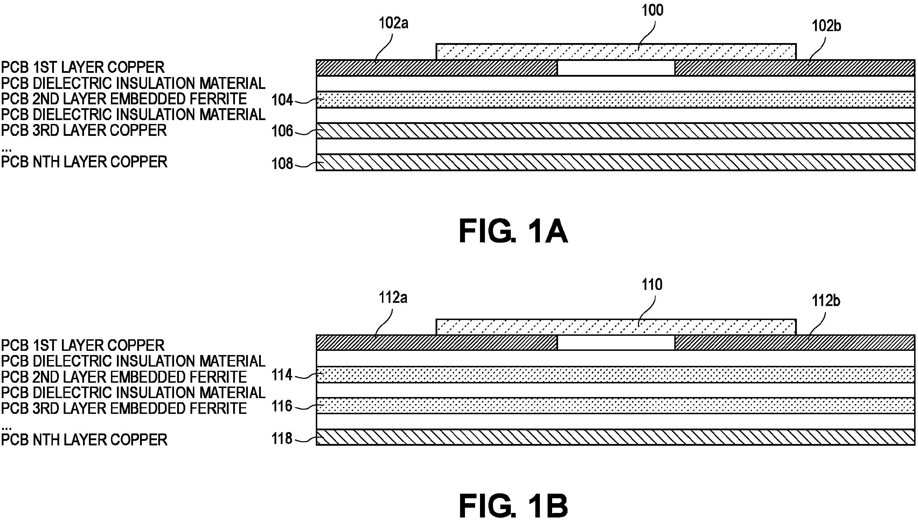

FIG. 1A-1G show side views of various examples of laminating ferrite into a PCB structure to create magnetic shielding for areas in lower layers within the PCB structure, in accordance with various embodiments. In embodiments, ferrite material is laminated as part of the PCB stack-up structure to replace either a copper (which may be referred to as a conductive) layer or a dielectric insulation, or both. Ferrite material placement within the PCB is defined during the PCB layout design so that the ferrite material can be placed exactly where magnetic shielding is required. This ferrite material layer, or layers, may be local to a particular region on the PCB, or may consist of the whole PCB area within the applicable layer(s) depending on application needs.

These techniques may be used to magnetically shield sensitive signals from magnetic disturbances such as may be generated by large currents on power delivery components, power supply traces, and copper planes. This may be useful in power delivery design. These techniques may also be used to conduct or direct magnetic fields generated by components on the PCB to designated areas inside and/or outside the PCB, depending on application. This implementation may be beneficial in applications where low frequency data communication is used, such as near field communication (NFC) applications.

FIG. 1A shows an inductor component 100 placed on a first layer of a PCB that includes copper conductors 102a, 102b that electrically couple with the inductor 100. In embodiments, during operation, the inductor component 100 and the copper conductors 102a, 102b, depending upon the current flowing through them, may generate a substantial magnetic field. The second layer of the PCB includes embedded ferrite 104 to shield the magnetic field generated by the inductor 100 and conductors 102a, 102b on the first layer. This shielding will protect subsequent signal routing in layers 106, 108 below the embedded ferrite 104 from magnetic fields generated during operation of the inductor 100 and conductors 102a, 102b on the first layer.

FIG. 1B shows an inductor 110, placed on top of a PCB, that is electrically coupled with copper conductors 112a, 112b in a first layer of the PCB. The next two PCB layers include embedded ferrite 114, 116 to provide magnetic shielding for signal routing at a lower layer 118 in the PCB. As compared to FIG. 1A, the layers of embedded ferrite 114, 116 will provide additional magnetic shielding. This may be due to a design choice of an inductor 110 that creates a very strong magnetic field during operation, or may be due to especially sensitive signal routing in layer 118.

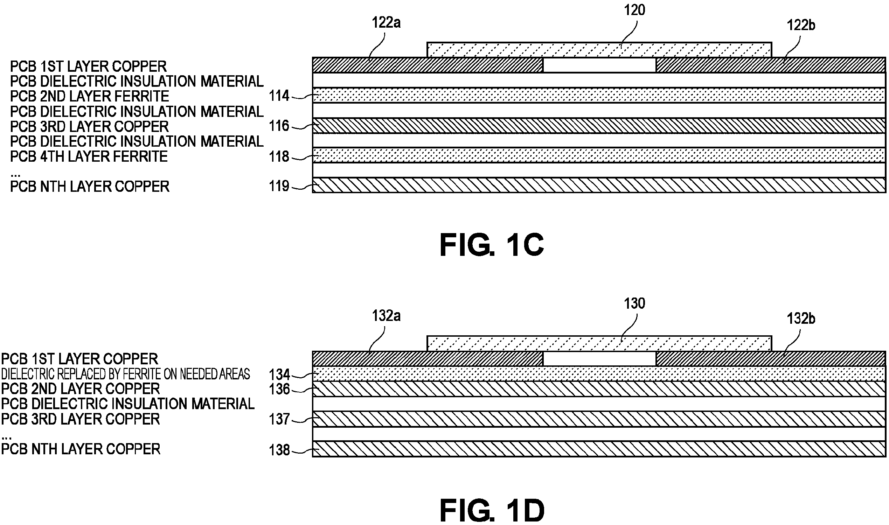

FIG. 1C shows a component 120 placed on top of a PCB, that is electrically coupled with copper conductors 122a, 122b in a first layer of the PCB. The second layer of the PCB may be an embedded ferrite layer 114 above a third layer copper current carrying conductor 116. In embodiments, the current carrying conductor 116 made include one or more current carrying conductors. The current carrying conductor 116, during operation, may generate a magnetic field that could negatively affect the operation of the component 120 but for the embedded ferrite layer 114. The fourth PCB layer may include embedded ferrite layer 118 to protect a signal routing layer 119 from the magnetic field generated by the current carrying conductor 116 during operation. In this way, the two embedded ferrite layers 114, 118 are able to protect the component 120 as well as the sensitive signal routing layer 119.

FIG. 1D shows an inductor 130 placed on top of a PCB, that is electrically coupled with copper conductors 122a, 122b in a first layer of the PCB. The first dielectric layer of the PCB is replaced with an embedded ferrite layer 134 to shield magnetic fields generated by the inductor from subsequent signal routing layers 136, 137, 138 of the PCB. In embodiments, the embedded ferrite layer 134 may be placed along the entire dielectric layer, or may be placed in portions where the magnetic field is to be blocked from signal routing in layers 136, 137, 138 below.

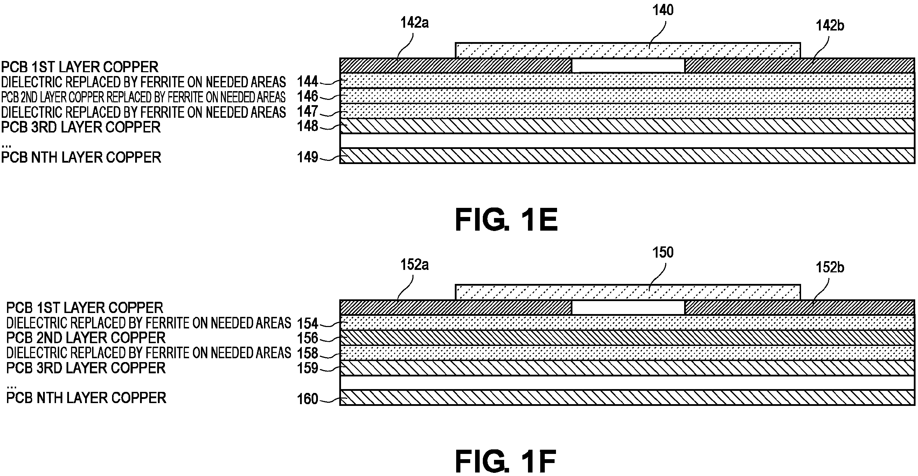

FIG. 1E shows an inductor 140 placed on top of a PCB, that is electrically coupled with copper conductors 142a, 142b in a first layer of the PCB. Here, three layers of embedded ferrite 144, 146, 147 are included in dielectric layers immediately above and below the PCB second layer, which may ordinarily be a copper layer. The structure of three embedded ferrite layers 144, 146, 147 provide a very strong shield against magnetic fields produced by inductor 140 against signal corruption for signal layers 148, 149. In other embodiments, any number of thicknesses of embedded ferrite may be created using multiple dielectric and PCB layers.

FIG. 1F shows a component 150 placed on top of a PCB, that is electrically coupled with copper conductors 152a, 152b in a first layer of the PCB. The second PCB copper layer 156 may include current carrying conductors that may generate magnetic fields during operation. Embedded ferrite layers 154, 158 in dielectric layers immediately above and immediately below the current carrying copper layer 156 are used to shield magnetic fields emanating from the current carrying conductor 156 during operation. In this way, the two signal routing layers 159, 160 are shielded from any generated magnetic fields.

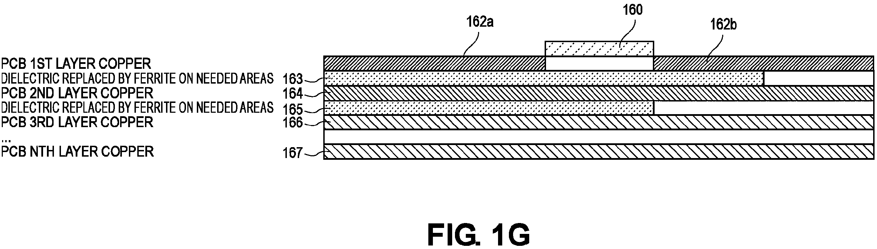

FIG. 1G shows a component 160 placed on top of a PCB, that is electrically coupled with copper conductors 162a, 162b in a first layer of the PCB. FIG. 1G may be similar to FIG. 1F, where the second PCB copper layer 164 may include current carrying conductors that may generate magnetic fields during operation. Embedded ferrite layers 163, 165 in portions of dielectric layers immediately above and immediately below the current carrying copper layer 156 are used to shield magnetic fields emanating from the current carrying conductor 164 during operation. This shielding protects signal routing in layers 159, 160 from magnetic fields during operation. As shown above, the ferrite layers may take up all or a portion of the PCB layer or a dielectric layer within the PCB.

It should be noted that the examples above are a small set of the possible examples of placement of embedded ferrite layers and positioning of components or traces that generate magnetic fields during operation of the PCB.

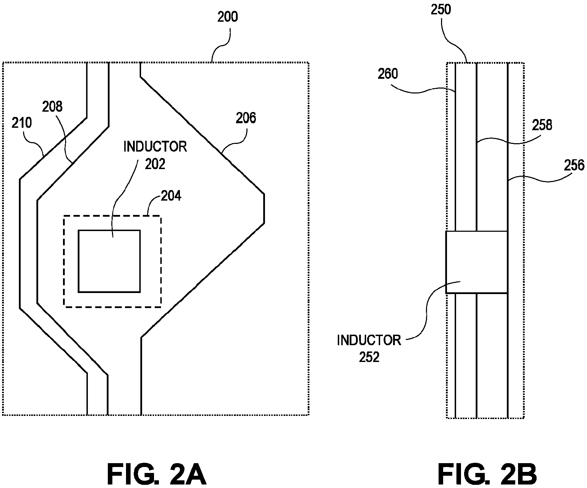

FIG. 2A-2B show top-down views of circuit routing on a PCB in a legacy implementation and an embodiments, in accordance with various embodiments. FIG. 2A shows a top-down view of a legacy implementation of a PCB 200. The PCB 200 includes an inductor 202 that generates a magnetic field during operation, with a keep out area 204. As a result, traces 206, 208, 210 need to be placed on the PCB such that they route around the keep out area 204 to avoid signal corruption due to magnetic field interference during operation of the PCB 200.

FIG. 2B shows a top-down view of an embodiment within PCB 250. The PCB 250 includes an inductor 252, with embedded ferrite layers, such as the layers described with respect to FIGs. 1A-1G above, between the inductor 252 and traces 256, 258, 260. The magnetic shielding property of the embedded ferrite layers between the inductor 252 and the traces 256, 258, 262 may reduce or completely remove the need for a keep out area, and allow traces 256, 258, 262 run directly under the inductor 252. As a result, much less PCB 250 area is required to run traces 256, 258, 260 past inductor 252 than is required for the area in PCB 200 to run traces 206, 208, 210 past inductor 202. In addition to PCB area saved, design and production costs may also be decreased using embodiments described herein.

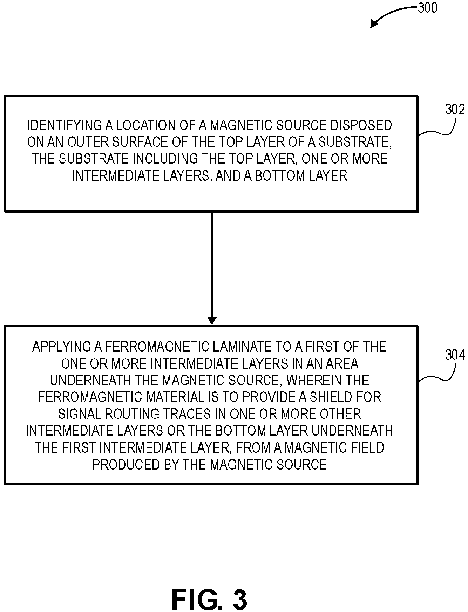

FIG. 3 is a process for applying ferromagnetic material to shield magnetic fields in a substrate, in accordance with various embodiments. Process 300 may be implemented using the components and techniques as described herein, and in particular with respect to FIGs. 1A-2B.

At block 302, the process may include identifying a location of a magnetic source disposed on an outer surface of the top layer of a substrate, the substrate including the top layer, one or more intermediate layers, and a bottom layer. In embodiments, the magnetic source may include inductor 100 of FIG. 1A, 110 of FIG. 1B, 130 of FIG. 1D, or 140 of FIG. 1E, or 252 of FIG. 2B.

At block 304, the process may include applying a ferromagnetic laminate to a first of the one or more intermediate layers in an area underneath the magnetic source, wherein the ferromagnetic material is to provide a shield for signal routing traces in one or more other intermediate layers or the bottom layer underneath the first intermediate layer, from a magnetic field produced by the magnetic source. In embodiments, the ferromagnetic laminate may include nickel ferrite NiFe2O4 or manganese ferrite MnFe2O4. in embodiments, the one or more intermediate layers may include the PCB copper (or conductive) layers and dielectric layers of FIG. 1A-1G.

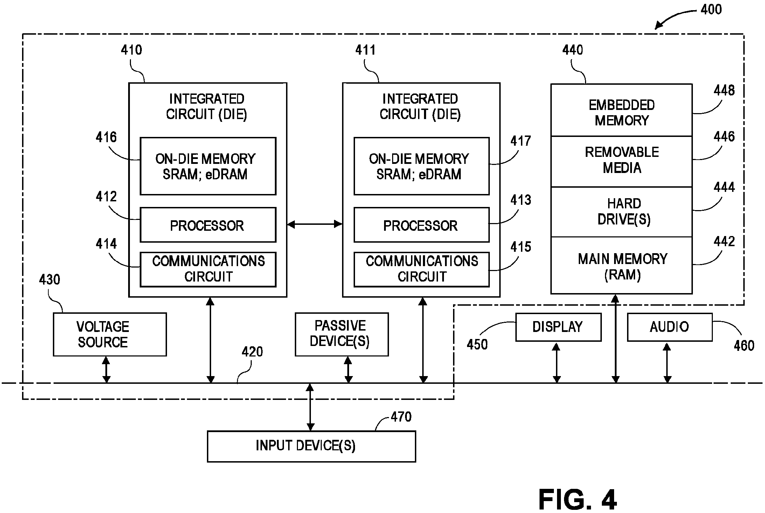

Embodiments of the present disclosure may be practiced in a system having suitable hardware and/or software to configure as desired. FIG. 4 schematically illustrates a computing device 400 in accordance with one embodiment. The computer system 400 (also referred to as the electronic system 400) as depicted can embody PCBs having ferromagnetic material in an intermediate layer to shield magnetic fields on a substrate, according to any of the several disclosed embodiments and their equivalents as set forth in this disclosure. In particular, one or more of the communication circuits 414, 415 may be implemented on a PCB embodyiing ferromagnetic material in an intermediate layer to shield magnetic fields on a substrate. The computer system 400 may be a mobile device such as a netbook computer. The computer system 400 may be a mobile device such as a wireless smart phone. The computer system 400 may be a desktop computer. The computer system 400 may be a hand-held reader. The computer system 400 may be a server system. The computer system 400 may be a supercomputer or high-performance computing system. Computer system 400 may also include a vehicle integrated computer system (such as in car, train, etc.)

In an embodiment, the electronic system 400 is a computer system that includes a system bus 420 to electrically and/or optically couple the various components of the electronic system 400. The system bus 420 is a single bus or any combination of busses according to various embodiments. The electronic system 400 includes a voltage source 430 that provides power to the integrated circuit 410. In some embodiments, the voltage source 430 supplies current to the integrated circuit 410 through the system bus 420.

The integrated circuit 410 is electrically coupled to the system bus 420 and includes any circuit, or combination of circuits according to an embodiment. In an embodiment, the integrated circuit 410 includes a processor 412 that can be of any type. As used herein, the processor 412 may mean any type of circuit such as, but not limited to, a microprocessor, a microcontroller, a graphics processor, a digital signal processor, a sensor, or another processor. In an embodiment, the processor 412 includes, or is coupled with, ferromagnetic material to shield magnetic fields on a substrate, as disclosed herein. In an embodiment, SRAM embodiments are found in memory caches of the processor. Other types of circuits that can be included in the integrated circuit 410 are a custom circuit or an application-specific integrated circuit (ASIC), such as a communications circuit 414 for use in wireless devices such as cellular telephones, smart phones, pagers, portable computers, two-way radios, and similar electronic systems, or a communications circuit for servers. In an embodiment, the integrated circuit 410 includes on-die memory 416 such as static random-access memory (SRAM). In an embodiment, the integrated circuit 410 includes embedded on-die memory 416 such as embedded dynamic random-access memory (eDRAM).

In an embodiment, the integrated circuit 410 is complemented with a subsequent integrated circuit 411. Useful embodiments include a dual processor 413 and a dual communications circuit 415 and dual on-die memory 417 such as SRAM. In an embodiment, the dual integrated circuit 410 includes embedded on-die memory 417 such as eDRAM.

In an embodiment, the electronic system 400 also includes an external memory 440 that in turn may include one or more memory elements suitable to the particular application, such as a main memory 442 in the form of RAM, one or more hard drives 444, and/or one or more drives that handle removable media 446, such as diskettes, compact disks (CDs), digital variable disks (DVDs), flash memory drives, and other removable media known in the art. The external memory 440 may also be embedded memory 448 such as the first die in a die stack, according to an embodiment.

In an embodiment, the electronic system 400 also includes a display device 450, an audio output 460. In an embodiment, the electronic system 400 includes an input device such as a controller 470 that may be a keyboard, mouse, trackball, game controller, microphone, voice-recognition device, or any other input device that inputs information into the electronic system 400. In an embodiment, an input device 470 is a camera. In an embodiment, an input device 470 is a digital sound recorder. In an embodiment, an input device 470 is a camera and a digital sound recorder.

As shown herein, the integrated circuits 410 and 411 can be implemented in a number of different embodiments, including being disposed on a PCB having ferromagnetic material in one or more intermediate layers of the PCB to shield magnetic fields on a substrate, according to any of the several disclosed embodiments and their equivalents. Similarly, an electronic system, a computer system, and one or more methods of fabricating an electronic assembly may include a PCB having ferromagnetic material in one or more intermediate layers of the PCB to shield magnetic fields on a substrate, according to any of the several disclosed embodiments as set forth herein in the various embodiments and their art-recognized equivalents. The elements, materials, geometries, dimensions, and sequence of operations can all be varied to suit particular I/O coupling requirements. A foundation multi-layer PCB may be included, as represented by the dashed line of FIG. 4. Passive devices may also be included, as is also depicted in FIG. 4.

In embodiments, each block 410, 411, and 440 may have its own optical transceivers so that they be optically connected to each other, i.e. they can send data from and to each other in the form of optical signals. Optical signals may be used to communicate within one block (410, 411, and 440) and between these blocks. Bus 420 can represent optical as well electrical buses.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated implementations, including what is described in the Abstract, is not intended to be exhaustive or to limit the embodiments of the present disclosure to the precise forms disclosed. While specific implementations and examples are described herein for illustrative purposes, various equivalent modifications are possible within the scope of the present disclosure, as those skilled in the relevant art will recognize.

These modifications may be made to embodiments of the present disclosure in light of the above detailed description. The terms used in the following claims should not be construed to limit various embodiments of the present disclosure to the specific implementations disclosed in the specification and the claims. Rather, the scope is to be determined entirely by the following claims, which are to be construed in accordance with established doctrines of claim interpretation.

Some non-limiting examples are provided below.

### Examples

Example 1 is an apparatus comprising: a substrate with a plurality of layers including a top layer, one or more intermediate layers and a bottom layer; and ferromagnetic material applied to a first of the one or more intermediate layers in an area underneath a magnetic source disposed on an outer surface of the top layer; wherein the ferromagnetic material is to provide a shield for signal routing traces in one or more other intermediate layers or the bottom layer underneath the first intermediate layer, from a magnetic field produced by the magnetic source.

Example 2 may include the apparatus of example 1, wherein the ferromagnetic material is a ferromagnetic laminate or a ferrite material.

Example 3 may include the apparatus of example 1, wherein the magnetic source is coupled with the substrate.

Example 4 may include the apparatus of example 1, wherein the magnetic source includes a selected one of: a trace that carries a high current, an inductor, a power inductor, a power plane, or a power delivery component.

Example 5 may include the apparatus of example 1, wherein the ferromagnetic material is applied to only a portion of the one or more of the plurality of layers.

Example 6 may include the apparatus of example 1, wherein a layer of the substrate is a selected one of: a dielectric layer or a conductive layer.

Example 7 may include the apparatus of example 1, wherein the ferromagnetic material is applied to a plurality of layers that are adjacent to each other.

Example 8 may include the apparatus of example 1, wherein the apparatus is a printed circuit board (PCB).

Example 9 may include the apparatus of any one of examples 1-8, wherein the apparatus includes the magnetic source.

Example 10 may include the apparatus of example 9, wherein the magnetic source includes a selected one of: a trace that carries a high current, an inductor, a power inductor, a power plane, or a power delivery component.

Example 11 is a method, comprising: identifying a location of a magnetic source disposed on an outer surface of the top layer of a substrate, the substrate including the top layer, one or more intermediate layers, and a bottom layer; and applying a ferromagnetic laminate to a first of the one or more intermediate layers in an area underneath the magnetic source, wherein the ferromagnetic material is to provide a shield for signal routing traces in one or more other intermediate layers or the bottom layer underneath the first intermediate layer, from a magnetic field produced by the magnetic source.

Example 12 may include the method of example 11, wherein the ferromagnetic laminate includes nickel ferrite NiFe2O4 or manganese ferrite MnFe2O4.

Example 13 may include the method of example 11, wherein the one or more intermediate layers includes a dielectric layer or a conductive.

Example 14 may include the method of example 13, wherein the one or more intermediate layers are adjacent layers.

Example 15 may include the method of example 11, wherein applying the ferromagnetic laminate further includes applying the ferromagnetic laminate to a portion of the one or more intermediate layers.

Example 16 may include the method of any one of examples 11-15, wherein the plurality of layers may be a dielectric layer or a conductive layer.

Example 17 is a system comprising: a magnetic source; a printed circuit board (PCB) coupled with the magnetic source, the PCB comprising: a plurality of layers; ferromagnetic material applied to one or more of the plurality of layers, wherein the ferromagnetic material is applied proximate to the magnetic source; and wherein the ferromagnetic material is to conduct a magnetic field within the PCB generated by the magnetic source.

Example 18 may include the system of example 17, wherein to conduct the magnetic field within the PCB further includes to conduct the magnetic field toward areas in the PCB to facilitate low-frequency data communication.

Example 19 may include the system of example 18, wherein low frequency data communication includes near field communication (NFC).

Example 20 may include the system of any one of examples 17-19, wherein to conduct the magnetic field within the PCB further includes to conduct the magnetic field away from copper traces within the PCB sensitive to the magnetic field.

## Claims

1. An apparatus comprising:
a substrate with a plurality of layers including a top layer, one or more intermediate layers and a bottom layer; and
ferromagnetic material applied to a first of the one or more intermediate layers in an area underneath a magnetic source disposed on an outer surface of the top layer;
wherein the ferromagnetic material is to provide a shield for signal routing traces in one or more other intermediate layers or the bottom layer underneath the first intermediate layer, from a magnetic field produced by the magnetic source.

2. The apparatus of claim 1, wherein the magnetic source is coupled with the substrate; and wherein the magnetic source includes a selected one of: a trace that carries a high current, an inductor, a power inductor, a power plane, or a power delivery component.

3. The apparatus of claim 1, wherein the ferromagnetic material is applied to only a portion of the one or more of the plurality of layers.

4. The apparatus of claim 1, wherein a layer of the substrate is a selected one of: a dielectric layer or a conductive layer.

5. The apparatus of claim 1, wherein the ferromagnetic material is applied to a plurality of layers that are adjacent to each other.

6. The apparatus of claim 1, wherein the apparatus is a printed circuit board (PCB).

7. The apparatus of any one of claims 1-8, wherein the apparatus includes the magnetic source; and wherein the magnetic source includes a selected one of: a trace that carries a high current, an inductor, a power inductor, a power plane, or a power delivery component.

8. A method, comprising:
identifying a location of a magnetic source disposed on an outer surface of the top layer of a substrate, the substrate including the top layer, one or more intermediate layers, and a bottom layer; and
applying a ferromagnetic laminate to a first of the one or more intermediate layers in an area underneath the magnetic source, wherein the ferromagnetic material is to provide a shield for signal routing traces in one or more other intermediate layers or the bottom layer underneath the first intermediate layer, from a magnetic field produced by the magnetic source.

9. The method of claim 8, wherein the ferromagnetic laminate includes nickel ferrite NiFe2O4 or manganese ferrite MnFe2O4.

10. The method of claim 8, wherein the one or more intermediate layers includes a dielectric layer or a conductive layer; and wherein the one or more intermediate layers are adjacent layers.

11. The method of any one of claims 8-10, wherein applying the ferromagnetic laminate further includes applying the ferromagnetic laminate to a portion of the one or more intermediate layers.

12. A system comprising:
a magnetic source;
a printed circuit board (PCB) coupled with the magnetic source, the PCB comprising:
a plurality of layers;
ferromagnetic material applied to one or more of the plurality of layers, wherein the ferromagnetic material is applied proximate to the magnetic source; and
wherein the ferromagnetic material is to conduct a magnetic field within the PCB generated by the magnetic source.

13. The system of claim 12, wherein to conduct the magnetic field within the PCB further includes to conduct the magnetic field toward areas in the PCB to facilitate low-frequency data communication.

14. The system of any one of claims 12-13, wherein to conduct the magnetic field within the PCB further includes to conduct the magnetic field away from copper traces within the PCB sensitive to the magnetic field.

15. An apparatus comprising:
means for identifying a location of a magnetic source disposed on an outer surface of the top layer of a substrate, the substrate including the top layer, one or more intermediate layers, and a bottom layer; and
means for applying a ferromagnetic laminate to a first of the one or more intermediate layers in an area underneath the magnetic source, wherein the ferromagnetic material is to provide a shield for signal routing traces in one or more other intermediate layers or the bottom layer underneath the first intermediate layer, from a magnetic field produced by the magnetic source.
